# EUROPEAN PATENT APPLICATION

(11) **EP 4 530 640 A1**
(43) Date of publication of application: **02.04.2025**
(21) Application number: 24199966.3
(22) Date of filing: 12.09.2024
(51) Int. Cl.: G01R 15/14, G01R 15/18

(54) **INTEGRATED SYSTEM IN PACKAGE FOR ELECTRIC-CURRENT MONITORING BASED ON MAGNETIC FIELD**

(30) Priority: 27.09.2023 IT 202300019944
(71) Applicant: STMicroelectronics International N.V., 1228 Plan-les-Ouates, Geneva (CH)
(72) Inventor: PATTI, Davide Giuseppe, 95030 MASCALUCIA (CT) (IT)
(74) Representative: Studio Torta S.p.A.

(57) **Abstract**

An integrated system (1) for electric-current monitoring is described, having: a package (2); a MEMS sensor device (12), arranged inside the package (2) to provide an output electrical signal indicative of the electric current to be monitored. The system has, inside the package (2), a sensing coil (20) traversed by the electric current to be monitored; the MEMS sensor device (12) is arranged relative to the sensing coil (20) so as to be invested by flux lines of a magnetic field generated as a whole by the sensing coil (20) as a function of the electric current to be monitored.

## Description

### TECHNICAL FIELD

The present solution relates to an integrated System-in-Package (so-called SiP) for electric-current monitoring based on magnetic field.

### BACKGROUND

In electronic devices or systems, for example for power analog applications, it is a known need to implement monitoring of the circulating electric current, in order to control and improve the operation of the same electronic devices or systems.

Known solutions for electric-current monitoring provide, for example: use of resistors arranged in series with a load and monitoring the voltage across the same resistors; or implementing current mirrors, using two power devices (for example MOSFET transistors) with different area and different on-state resistance RDSₒₙ, parallel-connected and driven with a same signal.

Further known solutions envisage use of Hall effect magnetic sensors, placed in proximity of the path that conducts the electric current towards the load, for example implemented by electric wire or conductive track.

Although they allow electric-current monitoring, the aforementioned known solutions have some drawbacks, for example in terms of area occupation or limitations in the operating frequency, which may be disadvantageous, at least for certain applications.

### SUMMARY

The present solution generally aims to overcome the limitations of known systems.

According to the present solution, a system is therefore provided, as defined in the attached claims.

### BRIEF DESCRIPTION OF THE FIGURES

For a better understanding of the present invention, a preferred embodiment thereof is now described, purely by way of non-limiting example and with reference to the attached drawings, wherein:
- Figure 1A shows a schematic top view (with parts removed for sake of clarity) of a system according to an embodiment of the present solution;
- Figure 1B shows a perspective view of the system of Figure 1A;
- Figures 2 and 3 are schematic top views of variant embodiments of the system according to the present solution;
- Figure 4 is a schematic section of a system according to a further embodiment of the present solution; and
- Figure 5 is a schematic perspective view of the system of Figure 4.

### DESCRIPTION OF EMBODIMENTS

One aspect of the present solution generally envisages formation of an integrated system in package to implement monitoring of an electric current circulating in an electronic device or system.

As will be described in detail below, the integrated system comprises, inside a same package: a coil designed to generate, as a function of an electric current to be monitored, an overall magnetic flux having a propagation central axis (which corresponds to the central axis of the coil); and a microelectromechanical sensor device (made using MEMS - Micro-Electro-Mechanical System - technology), operating as a magnetometer, arranged along the aforementioned central axis to be invested by the overall magnetic flux generated by the coil and to output a sensing signal indicative of the aforementioned electric current to be monitored.

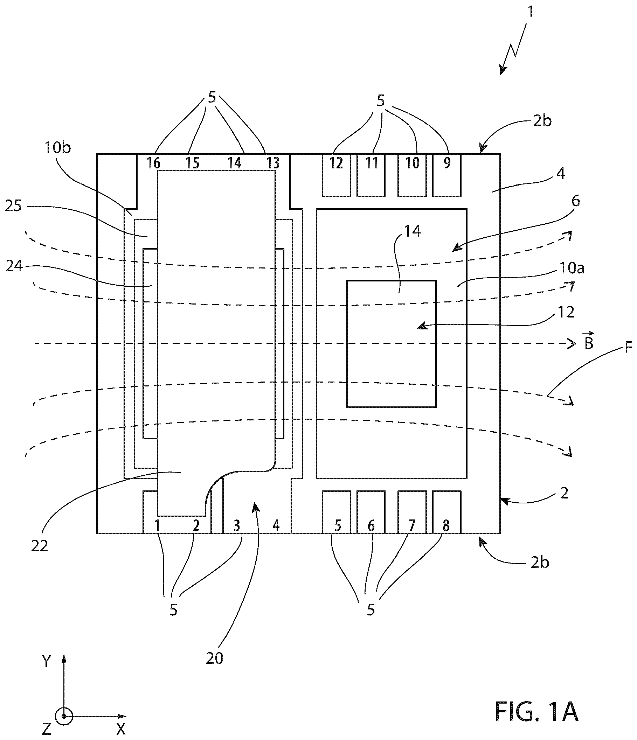

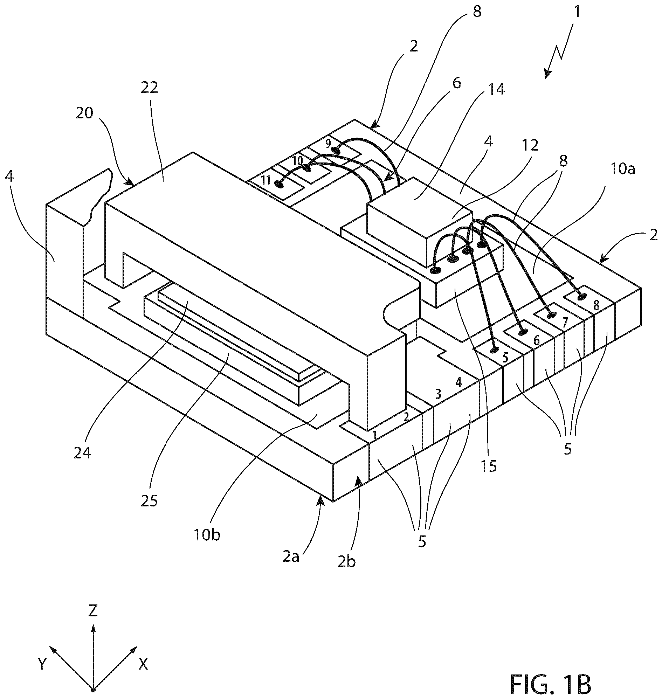

In detail, and referring first to a possible embodiment shown in Figures 1A and 1B, the current monitoring system, indicated as a whole by 1, comprises a package 2, in the example of a QFN (Quad-Flat No-leads) type having a substantially parallelepiped shape; however, it is emphasized that other types of packages (and other shapes) may also be provided, as will also be highlighted hereinbelow.

The package 2 comprises a coating 4, of epoxy resin or another type of material (for example a ceramic material), which represents the interface of the system 1 towards the external environment and encloses and houses within the elements which are part of the same system 1.

The package 2 also comprises leads or electrical contact terminals 5, of a conductive material, for example aluminum, arranged externally with respect to the coating 4 and accessible from the outside (being flush with the same coating 4), in particular at a lateral surface 2b of the package 2 and at a lower surface 2a of the same package 2 designed to be coupled to a Printed Circuit Board (PCB) of an external electronic device wherein the system 1 is used for monitoring the circulating electric current.

In the illustrated embodiment, the aforementioned electrical contact terminals 5 are arranged in two parallel rows, at opposite faces of the lateral surface 2b of the package 2. In particular, in the example, the electrical contact terminals 5 of each row are in a number equal to 8 (therefore being indicated with progressive numbers 1 to 8 for a first row and 9 to 16 for a second row) aligned along a first horizontal axis x of a horizontal plane xy of main extension of the aforementioned package 2 (considering a thickness of the package 2 referred to a vertical axis z, orthogonal to the aforementioned horizontal plane xy).

The package 2 internally comprises, encased by the coating 4, a support structure or frame 6 (commonly referred to as "leadframe"), made of a conductive material, for example copper, which carries the aforementioned elements which are part of the system 1. Bonding wires 8 suitably connect these elements to respective electrical contact terminals 5 (as will also be highlighted below).

The frame structure 6, which has a main extension in the horizontal plane xy, comprises two isles (or pads), in particular a first and a second isles 10a, 10b, distinct and separate and mechanically and electrically insulated from each other, arranged side by side in the aforementioned horizontal plane xy and having in the example a substantially rectangular shape.

In particular, the first isle 10a carries a microelectromechanical (MEMS) sensor device, operating as a magnetometer (hereinafter therefore referred to as MEMS magnetometer device 12) and comprising: a first die 14, of semiconductor material (for example silicon), which integrates a suitable magnetic field sensing structure, for example of a capacitive type and based on the Lorentz force (of a known type, not described in detail herein); and a second die 15, of semiconductor material, which integrates an ASIC (Application Specific Integrated Circuit) electronic circuit, operationally and electrically coupled to the aforementioned sensing structure to provide an output electrical signal indicative of the sensed magnetic field (and therefore of the electric current to be monitored, which has generated the same magnetic field).

In the illustrated example, the second die 15 is arranged on the first isle 10a and the first die is superimposed on the second die 5.

The aforementioned bonding wires 8 electrically connect pads carried by an upper surface (not in contact with the first isle 10a) of the second die 15 to respective electrical contact terminals 5 (in the example those indicated with progressive numbers 5 to 8 and 9 to 11), to receive electrical biasing signals from the external electronic device and provide at the output, to the same external electronic device, the aforementioned output electrical signal indicative of the electric current to be monitored.

It is highlighted that the sensing structure integrated into the first die 14 may have further functionalities in addition to the electric-current monitoring, for example functionalities for sensing at least one further quantity of interest (an acceleration, an angular velocity, a pressure, a temperature, or any other quantity).

Furthermore, above the same first isle 10a (or above a further and distinct isle of the frame structure 6 inside the package 2), the system 1 may comprise at least one further die, configured to integrate at least one further micromechanical structure (and/or ASIC circuit), for example for sensing at least one respective quantity of interest.

According to a particular aspect of the present solution, the second isle 10b is configured to form, at least in part, a sensing coil 20, designed to be traversed by the electric current to be monitored and generate a resulting sensing magnetic field, as a function of this electric current.

In detail, the sensing coil 20 comprises a first bridge element 22, arranged above the aforementioned second isle 10b (at a certain separation distance therefrom along the vertical axis z) and made of a conductive material, for example copper.

This first bridge element 22 forms, in conjunction with the underlying second isle 10b, the sensing coil 20, having in this case a single-turn arrangement; this sensing coil 20 therefore has a three-dimensional arrangement inside the package 2 (having extension both in the horizontal plane xy and along the vertical axis z).

In particular, the flux of the sensing magnetic field, indicated with F in the aforementioned Figure 1A, generated as a whole by the sensing coil 20 in response to the flow of the electric current to be monitored, has flux lines with a central axis B directed along the first horizontal axis x, corresponding to a central axis of the same sensing coil 20.

According to one aspect of the present solution, the MEMS magnetometer device 12 is arranged in the package 2 in such a way as to be invested by the lines of the magnetic flux F, in particular being arranged at the aforementioned central axis B.

As shown in the aforementioned Figure 1B, a ferromagnetic material region 24 may also be provided, arranged below the first bridge element 22, interposed between the same first bridge element 22 and the second isle 10b of the frame structure 6; in the illustrated embodiment, this ferromagnetic material region 24 is carried by a support 25, for example made of silicon, arranged on the second isle 10b.

This ferromagnetic material region 24 may be made of an alloy of Iron and Nickel (NiFe), Nickel and Cobalt or other suitable material or alloy of materials.

The aforementioned second isle 10b is directly connected to some of the aforementioned electrical contact terminals 5, which are an extension thereof in the horizontal plane xy, so as to define the path of the electric current to be monitored, at the input of the sensing coil 20 or at the output of the same sensing coil 20.

In detail, in the embodiment illustrated in the aforementioned Figures 1A and 1B, the electrical contact terminals 5 indicated with the numbers 1 and 2 (electrically short-circuited to each other) are dedicated to input of the electric current (and are therefore referred to as input terminals); these input terminals are electrically separated from the second isle 10b and contacted by a first distal portion (shaped as a pillar) of the bridge element 22.

The electrical contact terminals 5 indicated with the numbers 3 and 4 (electrically short-circuited to each other), adjacent to the aforementioned input terminals in the same row along the first horizontal axis x, are dedicated to output of the electric current (and are therefore referred to as output terminals) ; these output terminals are connected directly to the second isle 10b and are an extension thereof in the horizontal plane xy.

Furthermore, the electrical contact terminals 5 indicated with progressive numbers 13 to 16, opposite to the aforementioned input and output terminals and placed in the opposite row, are electrically short-circuited to each other and contacted directly by the second isle 10b, being an extension thereof in the horizontal plane xy; furthermore, these terminals (indicated by the numbers 13 to 16) are contacted by a second distal portion (shaped as a pillar) of the first bridge element 22 (this second distal portion having an extension along the first horizontal axis x greater than the aforementioned first distal portion).

The aforementioned electrical contact terminals 5 from 13 to 16 may, in use, be left floating (i.e. not connected to any electrical potential).

Consequently, a current path is generated inside the sensing coil 20 which starts from the input terminals; traverses the first bridge element 22 (in particular, a corresponding span), in the direction of a second horizontal axis y (orthogonal to the aforementioned first horizontal axis x and defining with this first horizontal axis x the horizontal plane xy) reaching the electrical contact terminals 5 from 13 to 16; traverses the second isle 10b in the opposite direction along the same second horizontal axis y; and comes out of the package 2 from the output terminals.

In this embodiment, therefore, the electric current goes into and comes out from a same side of the package 2 (at which the aforementioned input and output terminals are formed).

The sensing coil 20 may, alternatively, comprise a greater number of turns.

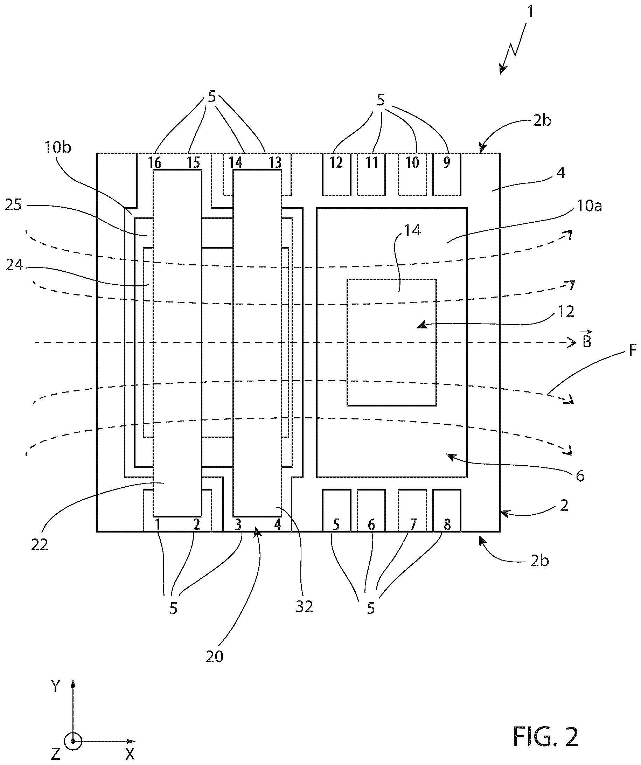

As shown in Figure 2, in a possible variant, the sensing coil 20 is formed of two turns and comprises, in addition to the first bridge element 22, a second bridge element 32, which also extends above the second isle 10b, crossing it along the second horizontal axis y, arranged parallel to the first bridge element 22.

In detail, in the embodiment illustrated in the aforementioned Figure 2, the input terminals (indicated with the numbers 1 and 2, electrically short-circuited to each other) dedicated to input of the electric current are again contacted by the first distal portion (shaped as a pillar) of the first bridge element 22.

The electrical contact terminals 5 indicated by numbers 3 and 4 are electrically short-circuited to each other and contacted by a respective first distal portion (shaped as a pillar) of the second bridge element 32 and are also in direct contact with the second isle 10b.

The electrical contact terminals 5 indicated with the progressive numbers 15 and 16, opposite to the aforementioned input terminals, are electrically short-circuited to each other and contacted directly by the second isle 10b and by the second distal portion (shaped as a pillar) of the first bridge element 22 (this second distal portion having in this case the same extension along the first horizontal axis x as the aforementioned first distal portion).

The aforementioned electrical contact terminals 5 from 3 to 4 and from 15 to 16 may, in use, be left floating (i.e. not connected to any electrical potential).

The output terminals in this case are the electrical contact terminals 5 indicated with the progressive numbers 13 and 14, which are electrically short-circuited to each other and contacted by the second distal portion (shaped as a pillar) of the second bridge element 32.

In this case, therefore, the current path inside the sensing coil 20 starts from the input terminals; traverses the first bridge element 22 in the direction of the second horizontal axis y up to reaching the electrical contact terminals 5 indicated by 15 and 16; traverses the second isle 10b in the opposite direction along the same second horizontal axis y reaching the electrical contact terminals 5 indicated by 3 and 4; and traverses the second bridge element 32 in the direction of the second horizontal axis y reaching the output terminals (in this case the aforementioned electrical contact terminals 5 indicated by 13 and 14) and then comes out of the package 2.

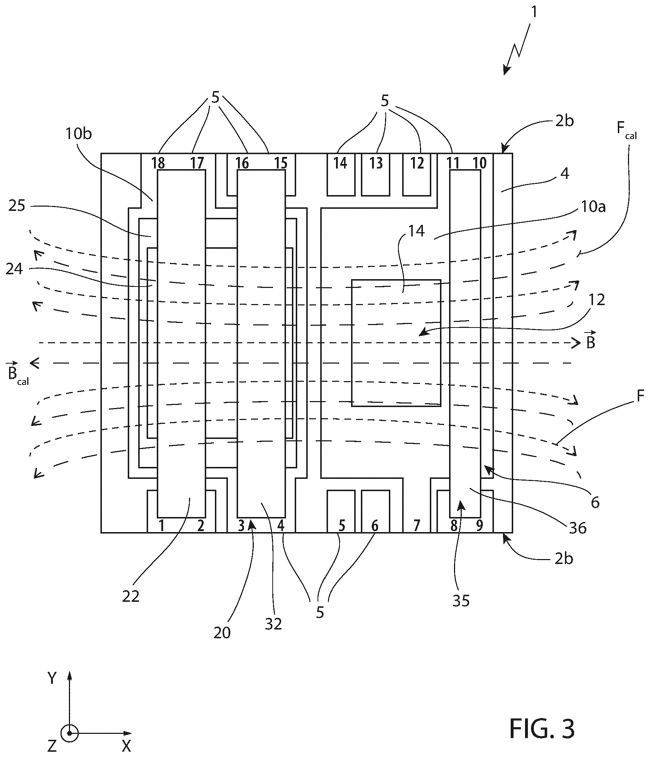

In a further embodiment, shown in Figure 3 with reference to the two-turns implementation of the sensing coil 20 (but what is illustrated applies regardless of the number of turns of the same sensing coil 20), the system 1 may comprise, in addition to the sensing coil 20, a calibration coil 35, integrated in the same package 2 in order to allow a calibration of the electric-current sensing, even by an end user (i.e., in a step subsequent to the manufacturing and to subsequent electrical testing steps).

This calibration coil 35, in the embodiment illustrated in the aforementioned Figure 3, comprises a respective bridge element 36 arranged above the first isle 10a, at a certain distance from the same first isle 10a (which carries, in a manner similar to what has been previously discussed, the MEMS magnetometer device 12).

Alternatively, in a manner not illustrated, the calibration coil 35 might be arranged above a different, further, isle formed in the frame structure 6 inside the package 2.

During operation, the calibration coil 35 is traversed by a calibration current (having a known value) for generating a calibration magnetic field, having a calibration magnetic flux indicated by F_{cal} in the aforementioned Figure 3, which has flux lines with a central axis *̅B̅_̅{̅c̅a̅l̅}̅*̅ directed along the first horizontal axis x, at the center of the same calibration coil 35, in a direction opposite to the flux lines of the sensing magnetic field.

The MEMS magnetometer device 12 is arranged in the package 2 interposed between the sensing coil 20 and the calibration coil 35, in such a way as to also be invested by the lines of the calibration magnetic flux F_{cal}, in particular being arranged at the aforementioned central axis *̅B̅*̅_{*̅c̅a̅l̅*̅.}

In greater detail, in the embodiment illustrated in the aforementioned Figure 3, the electrical contact terminals 5 indicated with the numbers 8 and 9 (in this case each row includes nine respective electrical contact terminals 5) are dedicated to the input of the calibration electric current; these input terminals are electrically separated from the first isle 10a and contacted by a first distal portion (shaped as a pillar) of the respective bridge element 36.

The sole electrical contact terminal 5 indicated by 7, adjacent to the aforementioned input terminals in the same row, is in this case dedicated to output of the calibration electric current; this output terminal is contacted directly by the first isle 10a.

Furthermore, the electrical contact terminals 5 indicated with the progressive numbers 10 and 11, opposite to the aforementioned input terminals (arranged in the opposite row), are electrically short-circuited to each other and contacted directly by the first isle 10a; these terminals are also contacted by a second distal portion (shaped as a pillar) of the respective bridge element 36.

The aforementioned electrical contact terminals 5 from 10 to 11 may, in use, be left floating (i.e. not connected to any electrical potential).

Consequently, a path is generated for the calibration electric current inside the calibration coil 35 which starts from the input terminal; traverses the respective bridge element 36 of the calibration coil 35, in the direction of the second horizontal axis y reaching the electrical contact terminals 5 indicated by 10 and 11; traverses the first isle 10a in the opposite direction along the same second horizontal axis y; and comes out of the single output terminal.

In this possible embodiment, the electrical contact terminals 5 available for the MEMS magnetometer device 12 are those indicated with the numbers 5-6 and 12-14.

What has been previously discussed with reference to Figure 2 applies in a substantially similar manner for this embodiment, with the only difference corresponding to the progressive number of the electrical contact terminals 5, in view of their different number inside each of the two parallel rows arranged laterally to the package 2.

The advantages of the proposed solution are clear from the preceding description.

In any case, it is emphasized that this solution allows measuring and/or monitoring an electric current in an analog power application in a very wide range of frequencies, from DC to several MHz.

Furthermore, the solution described allows an electric-current sensor to be formed in an extremely small volume, inside a package of an integrated system, with an area occupation that is much lower than that of traditional solutions (using discrete components, such as resistors, transistors or Hall effect sensors).

As previously indicated, the possibility may also be advantageous of using, for implementing the system 1, the package of a MEMS device that may already be present in the electronic system wherein the electric current to be monitored circulates, for example a MEMS sensor device, such as an accelerometer, a gyroscope, a pressure sensor or the like.

In particular, for implementing the system 1, the package of this MEMS device may be modified to include an isle, arranged in an insulated manner in the frame structure, so as to form the sensing coil, which includes this isle to form the path traversed by the electric current to be monitored; and also to include a suitable magnetometer sensing structure, for example of a capacitive type based on the Lorentz force (or, alternatively, based on other magnetic field measurement principles).

Furthermore, in the solution described, the MEMS sensor device, being configured to sense the overall axial field generated by the sensing coil, is typically not affected by external magnetic disturbances (such disturbances being in fact generally orders of magnitude lower than the magnetic field to be sensed).

Finally, it is clear that modifications and variations may be made to what has been described and illustrated herein without thereby departing from the scope of the present invention, as defined in the attached claims.

In particular, a different mutual arrangement might be provided in the system 1 between the sensing coil 20 and the MEMS magnetometer device 12, placed in any case along the central axis associated with the coil, so as to be invested by the magnetic field flux generated as a whole by the same sensing coil 20.

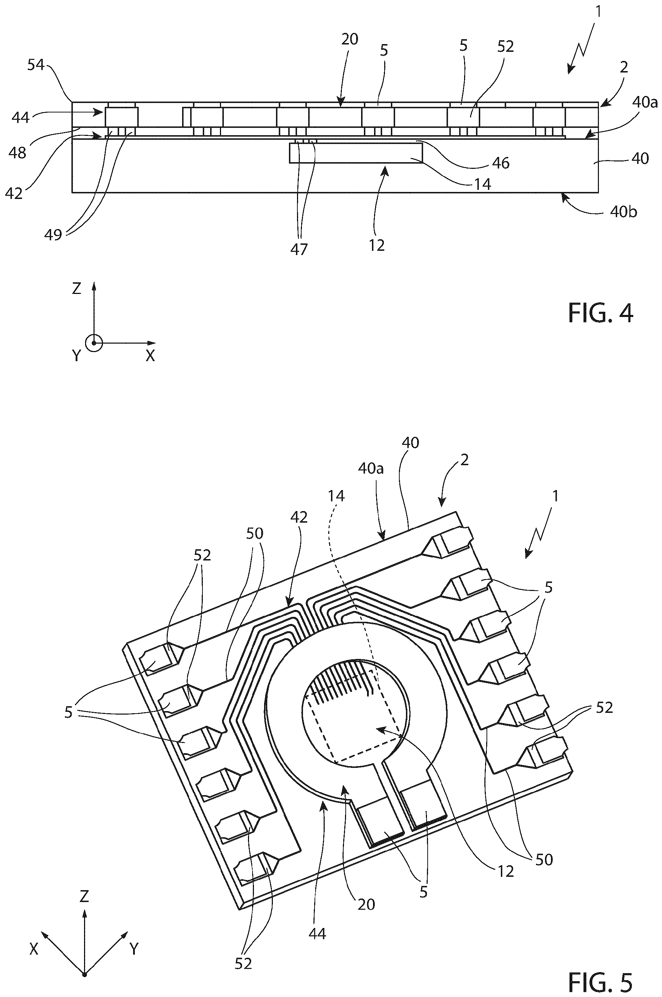

In this regard, Figures 4 and 5 show a further possible embodiment of the system 1, wherein the MEMS magnetometer device 12 and the sensing coil 20 are arranged, in a three-dimensional manner in the package 2, in a stack along the vertical axis Z.

In this embodiment, the MEMS magnetometer device 12 (in particular the corresponding first die 14 and possibly, in a manner not illustrated here, the corresponding second die 15) is incorporated in a base substrate 40 of the package 2, for example of epoxy resin.

This base substrate 40 has a first main surface 40a in the horizontal plane xy, at which the MEMS magnetometer device 12 is arranged, and a second main surface 40b, which defines an external (upper) surface of the same package 2.

Above the first main surface 40a of the base substrate 40, the package 2 has a first Redistribution Layer (RDL) 42, for example of copper, having a first thickness, for example of about 30 pm.

Above this first redistribution layer 42 a second redistribution layer 44, for example also of copper, is present having a second thickness, greater than the first thickness, for example equal to about 150 pm.

The first redistribution layer 42 is separated from the first die 14 by a first dielectric layer 46, having first through vias 47, of conductive material, formed therethrough; similarly, the second redistribution layer 44 is separated from the first redistribution layer 42 by a second dielectric layer 48, having second through vias 49, also of conductive material, formed therethrough.

In particular, according to an aspect of the present embodiment, the first redistribution layer 42 is patterned to define electrical connection tracks 50 above the first main surface 40a; and the second redistribution layer 44 is patterned to define contact pads 52, arranged at respective ends of the aforementioned electrical connection tracks 50, laterally to the package 2, and furthermore to define the aforementioned sensing coil 20.

In this case, this sensing coil 20 has a single-turn arrangement, shaped as a Q in the horizontal plane xy, and is arranged vertically above the MEMS magnetometer device 12, so that the same MEMS magnetometer device 12 is in a central position with respect to the aforementioned single turn, along a central axis thereof.

The electrical contact terminals 5 of the package 2 are formed above the contact pads 52; furthermore, a coating layer 54 coats the aforementioned second redistribution layer 44, except for the same electrical contact terminals 5 (which are accessible from the outside of the package 2).

As illustrated in the aforementioned Figure 5, a first and a second of the aforementioned electrical contact terminals 5 are connected to respective ends of the turn of the sensing coil 20, in such a way as to allow input and output of the electric current to be monitored. The remaining electrical contact terminals 5, arranged in two parallel rows laterally on opposite sides of the package 2, may be connected to the MEMS magnetometer device 12 through the aforementioned electrical connection tracks 50.

Similarly to what has been previously discussed, also in this embodiment, the system 1, integrated in the package 2, therefore envisages that the MEMS magnetometer device 12, inside the package 2, is invested by the flux of the concentrated magnetic field generated by the sensing coil 20, being arranged along the central axis of the same flux (which corresponds in this case to the central axis of the aforementioned Q-shaped turn of the sensing coil 20).

In a manner not illustrated in detail, a further variant embodiment may also be provided, with an inverted arrangement along the vertical axis z of the sensing coil 20 (in this case formed in the first redistribution layer 42) and of the MEMS magnetometer device 12, in this case superimposed on the sensing coil 20, being again arranged on a different plane with respect to the same sensing coil 20 along the vertical axis z.

Finally, it is again underlined that the MEMS sensor device 12 integrated in the package 2 may have further functions in addition to magnetic-field sensing to provide the output electrical signal indicative of the electric current to be monitored. For example, the MEMS sensor device 12 may have gyroscope, accelerometer, pressure sensor, or similar functions.

## Claims

1. An integrated system (1) for electric-current monitoring, comprising:
a package (2);
a MEMS sensor device (12), arranged inside the package (2) and configured to provide an output electrical signal indicative of the electric current to be monitored,
**characterized by** comprising, inside the package (2), a sensing coil (20) designed to be traversed by the electric current to be monitored; wherein the MEMS sensor device (12) is arranged relative to said sensing coil (20) so as to be invested by flux lines of a magnetic field generated as a whole by said sensing coil (20) as a function of said electric current to be monitored.

2. The system according to claim 1, wherein said MEMS sensor device (12) comprises a magnetometer, configured to generate said output electrical signal indicative of the electric current to be monitored, as a function of said magnetic field.

3. The system according to claim 1 or 2, wherein said MEMS sensor device (12) is arranged along a central axis of the flux of said magnetic field, which corresponds to a central axis of said sensing coil (20).

4. The system according to any of the preceding claims, comprising a frame structure (6) inside the package (2), incorporated in a coating (4) of said package (2); wherein said frame structure (6) has a main extension in a horizontal plane (xy) and comprises a first and a second isles (10a, 10b), distinct and separate and electrically insulated from each other, arranged side by side in the aforementioned horizontal plane (xy); and wherein said first isle (10a) carries the MEMS sensor device (12) and said second isle (10b) is configured to form, at least in part, said sensing coil (20) and a path for said electric current to be monitored.

5. The system according to claim 4, wherein said sensing coil (20) comprises a first bridge element (22), arranged above said second isle (10b) and made of a conductive material; wherein said first bridge element (22) forms, with the underlying second isle (10b), a first turn of said sensing coil (20) and the path for said electric current to be monitored.

6. The system according to claim 4 or 5, wherein said package (2) comprises electrical contact terminals (5), of a conductive material, arranged externally to the coating (4) and accessible from outside of said package (2); wherein said second isle (10b) is directly connected to first of said electrical contact terminals (5), which are an extension thereof in the horizontal plane (xy), to define, in the path of the electric current to be monitored, at least one of an input to the sensing coil (20) or an output from the sensing coil (20); and wherein said first bridge element (22) is directly connected to second of said electrical contact terminals (5) through a first end portion, to define, in the path of the electric current to be monitored, the other of the input to the sensing coil (20) or the output from the sensing coil (20).

7. The system according to claim 6, wherein further of said electrical contact terminals (5) are connected to said MEMS sensor device (12) by means of respective bonding wires (8) .

8. The system according to claim 6 or 7, wherein a second end of said first bridge element (22) is directly connected to said second isle (10b).

9. The system according to any of claims 5-8, wherein said sensing coil (20) comprises a second bridge element (32), arranged above said second isle (10b) and made of a conductive material, arranged side by side to said first bridge element (22) to define a second turn of said sensing coil (20).

10. The system according to claim 9, wherein said package (2) comprises electrical contact terminals (5), of a conductive material, arranged externally to the coating (4) and accessible from outside of said package (2); wherein said second isle (10b) is directly connected to first of said electrical contact terminals (5), which are an extension thereof in the horizontal plane (xy), to define a path of the electric current to be monitored in said sensing coil; and wherein said first bridge element (22) is directly connected to second of said electrical contact terminals (5) through a first end portion, to define, in the path of the electric current to be monitored, one of the input to the sensing coil (20) or the output from the sensing coil (20); and said second bridge element (32) is directly connected to third of said electrical contact terminals (5) through a respective end portion, to define, in the path of the electric current to be monitored, the other of the input to the sensing coil (20) or the output from the sensing coil (20) .

11. The system according to any of claims 4-10, further comprising, in addition to the sensing coil (20), a calibration coil (35), integrated inside the package (2), designed to be traversed by a calibration current for generation of a calibration magnetic field; wherein said calibration coil (35) comprises a respective bridge element (36) arranged above the first isle (10a); and wherein said MEMS sensor device (12) is arranged in the package (2) interposed between the sensing coil (20) and the calibration coil (35), in such a way as to also be invested by the flux lines of the calibration magnetic field.

12. The system according to any of claims 1-3, wherein said package (2) has a horizontal plane (xy) of main extension; and wherein the MEMS sensor device (12) and the sensing coil (20) are arranged in the package (2) in a stack along a vertical axis (z), orthogonal to said horizontal plane (xy), so that the MEMS sensor device (12) is in a central position relative to the sensing coil (20) along a central axis of said sensing coil (20) and is invested by flux lines of the magnetic field, directed along said vertical axis (z).

13. The system according to claim 12, wherein said MEMS sensor device (12) comprises a die (14) of semiconductor material incorporated in a base substrate (40) of the package (2); wherein said base substrate (40) has a first main surface (40a) in the horizontal plane (xy), at which the MEMS sensor device (12) is arranged, and a second main surface (40b), which defines an external surface of the package (2); wherein a redistribution layer (44), of a conductive material, is arranged above the first main surface (40a), separated from the first main surface (40a) by a dielectric layer (48), having through vias (49) formed therethrough, said redistribution layer (44) being patterned to define said sensing coil (20).

14. The system according to claim 13, wherein said sensing coil (20) has a single-turn arrangement in the horizontal plane (xy), defined in said redistribution layer (44) .

15. The system according to claim 13 or 14, wherein a conductive layer (42) is patterned above the first main surface (40a) to define electrical connection tracks (50) towards said MEMS sensor device (12); wherein said redistribution layer (44) is arranged above the conductive layer (42), separated from said conductive layer (42) by said dielectric layer (48).
